# EUROPEAN PATENT APPLICATION

(11) **EP 2 654 092 A2**
(43) Date of publication of application: **23.10.2013**
(21) Application number: 13163724.1
(22) Date of filing: 15.04.2013
(51) Int. Cl.: H01L 33/48, H01L 33/62

(54) **Light-emitting diode package**

(30) Priority: 16.04.2012 TW 101113413
(71) Applicant: Lextar Electronics Corp., 30075 Hsinchu (TW)
(72) Inventor: Ko, Bo-Yu, 220 New Taipei City (TW); Wang, Pu, 335 Taoyuan County (TW); Wang, Chun Wei, 237 New Taipei City (TW)
(74) Representative: Fuchs

(57) **Abstract**

The present invention provides an LED packaging structure comprising a leadframe, including: a first electrode (104) including a first functional area (104A) and a first extension area (104B) extending from the first functional area: a second electrode (110) including a second functional area (110A) and a second extension area (110B) extending from the second functional area, a cup-shaped insulator (124), wrapping the first and second electrodes, including an emitting concave formed at the inner side of the cup-shaped insulator and exposing the upper surfaces of the first and second functional areas, wherein portions of the first and second extension areas are exposed from the bottom of the outer side of the cup-shaped insulator; an interposed spacer (13 physically separating the first and second electrodes; and an electroplating layer partially covering the surfaces of the first and second electrodes.

## Description

### CROSS REFERENCE TO RELATED APPLICATIONS

This Application claims priority of Taiwan Patent Application No. 101113413, filed on April 16, 2012, the entirety of which is incorporated by reference herein.

### BACKGROUND

### Technical Field

The present disclosure relates to a light-emitting diode package. More particularly, the present disclosure relates to a light-emitting diode package including a side electrode coated with an electroplating layer.

### Description of the Related Art

Light-emitting diode (LED) leadframes are components which may carry emitting chips, connect the emitting chips to outer electrodes, and enhance emitting efficiency and heat dissipation of the emitting chips. The LED leadframes are formed of a metal plate and are usually formed by the following steps: such as shaping; electroplating, and insert molding. The LED leadframes are connected in an array form, called an LED leadframe array plate.

The LED package may be classified as a top-emitting type or a side-emitting type, for meeting the requirements of various applications. The top-emitting type LED package has a light-emitting plane and a soldering plane parallel to each other, and the side-emitting type LED package has a light-emitting plane and a soldering plane vertical to each other. In addition, the LED leadframe array plate may be classified as a connection type, in which the leadframes are arranged, or a separating type, in which the leadframes are independently arranged.

In the final products, the LED packaging pieces are separated from the leadframe array plate by dicing the leadframe array plate. Thus, each of the LED packaging pieces may have a cut surface of the leadframe array plate. For example, the exposed surface of the separated LED packaging pieces due to the dicing process is formed of the raw material of the leadframe array plate. It is difficult for the raw material of the leadframe array plate to be soldered, and it is easily oxidized. Thus, the exposed surfaces of LED packaging pieces may have abnormally high resistance, as well as resulting in the possibility of measuring incorrect electrical results.

In typical arrangements, the electrodes are disposed at the bottom of the LED packages. To meet the requirements of various designs and to present an attractive appearance, the electrodes are sometimes the sidewalls of the LED packages. As described above, the LED packaging pieces are separated by the dicing process, and the exposed surfaces of the LED packaging pieces are formed from the cut surfaces of the leadframe array plate. Thus, the exposed surface areas of the side electrode of the LED packaging pieces are determined by the thickness of the leadframe array plate. When the thickness of the leadframe array plate is increased, the total thickness of the LED packaging pieces will be also increased, and the usage amount of the metal materials will be largely increased.

An electroplating layer may be coated on the electrodes for maintaining the electrical properties of the LED packaging pieces. However, the coating step of the electroplating layer is performed before the dicing process. Thus, the exposed surfaces of the side electrode of the LED packaging pieces are not coated with the electroplating layer. In other words, the surfaces of the side electrode of the LED packaging pieces are formed of the raw material of the leadframe, such as copper. Copper is easily oxidized. Thus, the electrical properties of the LED packages cannot be measured from the side electrodes. In addition, solder does not easily adhere to the copper surface. Thus, the LED packaging pieces are hard to adhere to a PCB substrate or other devices via soldering the side electrode.

Thus, a novel LED package having a side electrode which has an enlarged surface area and is covered by an electroplating layer and a method fabrication thereof are needed.

### SUMMARY

The present disclosure provides a light-emitting diode package, including: a leadframe, including: a first electrode including a first functional area and a first extension area extending from the first functional area; a second electrode including a second functional area and a second extension area extending from the second functional area, a cup-shaped insulator, wrapping the first electrode and the second electrode, including an emitting concave formed at the inner side of the cup-shaped insulator and exposing the upper surfaces of the first functional area and the second functional area, wherein portions of the first extension area and the second extension area are exposed from the bottom of the outer side of the cup-shaped insulator; an interposed spacer disposed at the bottom of the cup-shaped insulator for physically separating the first electrode and the second electrode; and an electroplating layer partially covering the surfaces of the first electrode and the second electrode.

### BRIEF DESCRIPTION OF THE DRAWINGS

The disclosure will now be described, by way of example, with reference to the accompanying drawings, in which:

FIG. 1A shows a three-dimensional view of an LED package according to an embodiment of the present disclosure.

FIG. 1B shows a top view of the LED package shown in FIG. 1A.

FIG. 1C shows a bottom view of the LED package shown in FIG. 1A.

FIG. 1D shows a side view of a second electrode of the LED package shown in FIG. 1A.

FIG. 1E shows a bottom view of a leadframe array plate according to an embodiment of the present disclosure.

FIG. 2A shows a three-dimensional view of an LED package according to another embodiment of the present disclosure.

FIG. 2B shows a top view of the LED package shown in FIG. 2A.

FIG. 2C shows a bottom view of the LED package shown in FIG. 2A.

FIG. 2D shows a side view of a second electrode of the LED package shown in FIG. 2A.

FIG. 2E shows a bottom view of a leadframe array plate according to another embodiment of the present disclosure.

FIG. 3A shows a three-dimensional view of an LED package according to yet another embodiment of the present disclosure.

FIG. 3B shows a top view of the LED package shown in FIG. 3A.

FIG. 3C shows a bottom view of the LED package shown in FIG. 3A.

FIG. 3D shows a side view of a second electrode of the LED package shown in FIG. 3A.

FIG. 3E shows a bottom view of a leadframe array plate according to yet another embodiment of the present disclosure.

FIGS. 4A and 4B illustrate a three-dimensional view and a top view of an LED package according to a further embodiment of the present disclosure, respectively

### Detailed Description

The following description is of the best-contemplated mode of carrying out the invention. This description is made for the purpose of illustrating the general principles of the invention and should not be taken in a limiting sense. For example, the formation of a first feature over, above, below, or on a second feature in the description that follows may include embodiments in which the first and second features are formed in direct contact, and may also include embodiments in which additional features may be formed between the first and second features, such that the first and second features may not be in direct contact. The scope of the invention is best determined by reference to the appended claims.

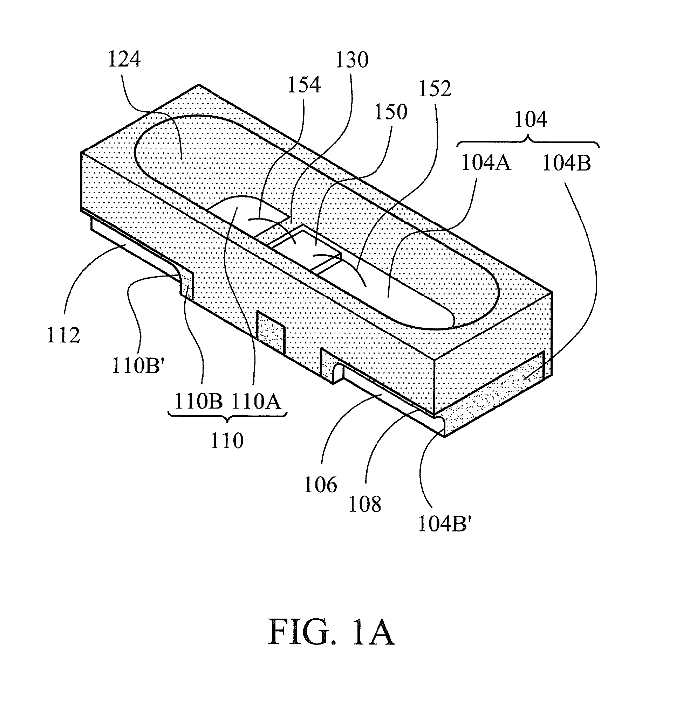

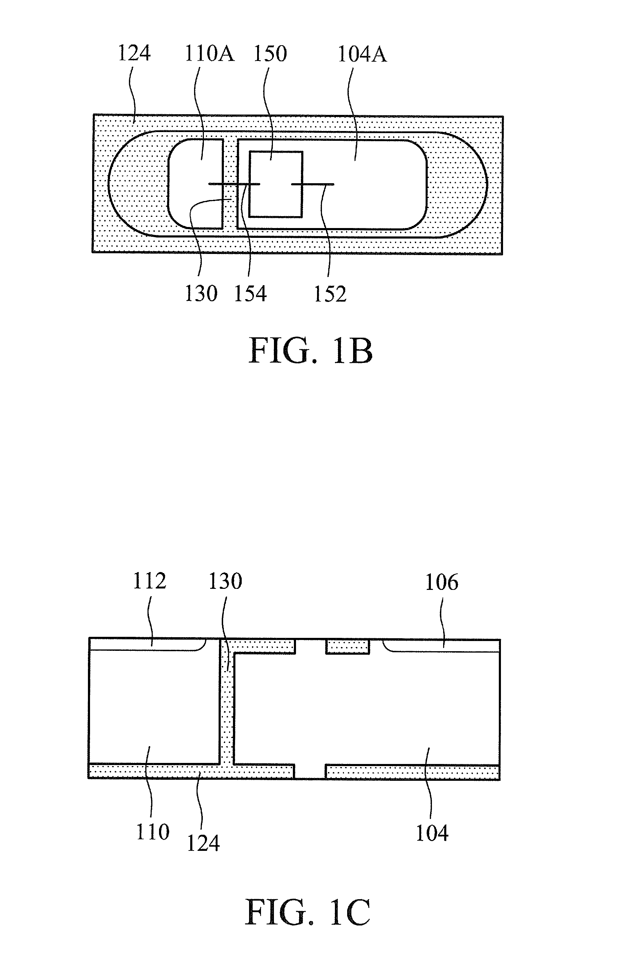

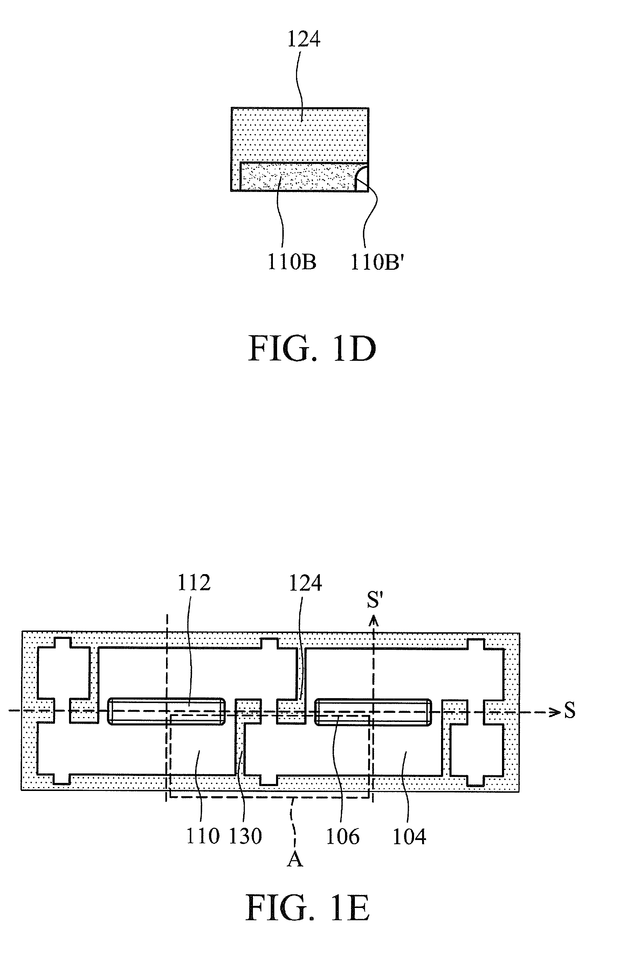

FIG. 1A shows a three-dimensional view of an LED package according to an embodiment of the present disclosure. FIG. 1B shows a top view of the LED package shown in FIG. 1A. FIG. 1C shows a bottom view of the LED package shown in FIG. 1A. FIG. 1D shows a side view of a second electrode of the LED package shown in FIG. 1A.

Referring to FIG. 1A, the LED package according to the present disclosure may comprise a first electrode 104 and a second electrode 110. The first electrode 104 and the second electrode 110 may be used as the electrodes of the LED package. The first electrode 104 and the second electrode 110 may have surfaces covered by an electroplating layer 108. The LED package is separated from the leadframe array plate, such as the leadframe array plate as shown in FIG. 1E. In an embodiment, the first electrode 104 and the second electrode 110 may be formed by stamping or dicing the leadframe array plate. Thus, the first electrode 104 and the second electrode 110 may comprise the raw material of the leadframe array plate, such as copper. In an embodiment, the electroplating layer 108 may be selected from the group consisting of silver and gold.

The first electrode 104 may comprise a first functional area 104A and a first extension area 104B extending from the first functional area 104A. The second electrode 110 may comprise a second functional area 110A and a second extension area 110B extending from second functional area 110A. A cup-shaped insulator 124 may be disposed on the first electrode 104 and the second electrode 110 and wrap the first electrode 104 and the second electrode 110. An emitting concave may be formed at the inner side of the cup-shaped insulator 124 and expose the upper surfaces of the first electrode 104 and the second electrode 110. An LED chip 150 may be mounted in the emitting concave. The LED chip 150 may electrically connect to the first functional area 104A of the first electrode 104 and the second functional area 110A of the second electrode 110. In an embodiment, the LED chip 150 may electrically connect to the first electrode 104 via a first wire 152 and electrically connect to the second electrode 110 via a second wire 154. An interposed spacer 130 may be disposed at the bottom of the emitting concave. The interposed spacer 130 may physically separate the first electrode 104 and the second electrode 110. For example, referring to FIG. 1B, edge portions of the upper surfaces of the first functional area 104A and the second functional area 110A may be covered by the cup-shaped insulator 124. Center portions of the upper surfaces of the first functional area 104A and the second functional area 110A may be exposed by the emitting concave. The cup-shaped insulator 124 may be formed of a thermosetting resin, such as epoxy resin, silicone resin or a combination thereof. The thermosetting resin may have better light and thermal resistances than the thermoplastic resin. Also, the thermosetting resin may have better plasticity and higher initial reflectance than the ceramic materials and silicon substrate. In an embodiment, the interposed spacer 130 and the cup-shaped insulator 124 may be formed of the same material.

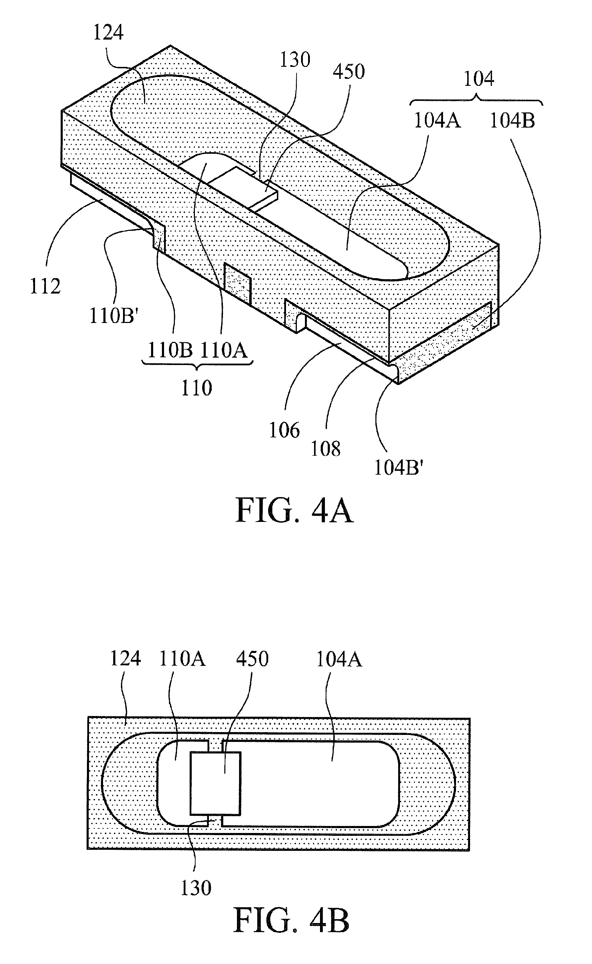

Furthermore, in addition to the above described wire bonding, the LED chip 150 may electrically connect to the first electrode 104 and the second electrode 110 by directly contacting to or fling-chip bonding. For example, referring to FIGS. 4A and 4B, illustrated are a three-dimensional view and a top view of an LED package according to another embodiment of the present disclosure, respectively. The first electrode 104 and the second electrode 110 may cross the interposed spacer 130 for connecting the first functional area 104A of the first electrode 104 and the second functional area 110A of the second electrode 110. Thus, the LED chip 450 may electrically connect to the first functional area 104A of the first electrode 104 and the second functional area 110A of the second electrode 110 by directly contacting to them or by flip-chip bonding (such as using solder, not shown).

Referring to FIGS. 1A to 1D again, the first extension area 104B of the first electrode 104 may be disposed at the outer side of the first functional area 104A and may have at least one portion exposed from the outer side of the cup-shaped insulator 124. The exposed portion of the first extension area 104B may be located at the bottom of the outer side of the cup-shaped insulator 124. The second extension area 110B of the second electrode 110 may be disposed at outer side of the second functional area 110A and may have at least one portion exposed from the outer side of the cup-shaped insulator 124. The exposed portions of the first extension area 104B and the second extension area 110B may be located at the bottom of the same side of the cup-shaped insulator 124. The first extension area 104B and the second extension area 110B may be used as side electrodes of the LED package. In addition, the first electrode 104 and the second electrode 110 may comprise a first recession area 106 and a second recession area 112, respectively. The first recession area 106 and the second recession area 112 may be located at the bottom of the same side of the cup-shaped insulator 124. The first recession area 106 and the second recession area 112 may have a height less than the thickness of the first functional area 104A and the second functional area 110A. For example, the first recession area 106 may be located at a corner of the LED package, and the second recession area 112 may be located at another corner of the LED package, wherein the two corners are located at the two ends of an edge of the LED package, respectively. The first recession area 106 may be a concave containing arc sidewalls 104B'. Similarly, referring to 1FG. 1D, the second recession area 112 may be a concave containing arc sidewalls 110B'. The size and shape of the first recession area 106 and the second recession area 112 may be varied according to the specific needs of various designs.

As described above, the first electrode 104 and the second electrode 110 may be formed by a dicing process, and the cut surfaces may be the exposed side surfaces of the first extension area 104B and the second extension area 110B. Thus, portions of the surfaces of the first extension area 104B and the second extension area 110B, such as the side surfaces of the first extension area 104B and the second extension area 110B in addition to the first and second recession areas 106 and 112, may be not covered by the electroplating layer 108. For example, the portions of the exposed side surface are naked copper surfaces. The first recession area 106 and the second recession area 112 may be covered by the electroplating layer 108 although they are located in the first extension area 104B and the second extension area 110B. In other words, in addition to the portions of surfaces of the first extension area 104B and the second extension area 110B which are not covered by the electroplating layer 108, the remaining portions of the surfaces of the first electrode 104 and the second electrode 110 may be covered by the electroplating layer 108. For example, referring to FIG. 1C, a portion of the sidewalls of the first electrode 104 and the second electrode 110 may be wrapped by the cup-shaped insulator 124, and the first electrode 104 and the second electrode 110 may be physically separated by the interposed spacer 130. The bottom surfaces of the first electrode 104 (including the first extension area 104A and the first extension area 104B) and the second electrode 110 (including the second extension area 110A and the second extension area 110B) are all covered by the electroplating layer 108. Note that the surfaces of the first recession area 106 and the second recession area 112 are also covered by the electroplating layer 108.

FIG. 1E shows a bottom view of a connection type leadframe array plate. The leadframe array plate may comprise a plurality of LED packaging pieces which are connected to each other. For example, the LED package shown in FIGS. 1A to 1D may be an LED packaging piece diced from the leadframe array plate. An area A may be defined by a plurality of parallel scribing line S and a plurality of parallel scribing lines S'. In an embodiment, the scribing lines S and the scribing lines S' may be substantially perpendicular to each other. Thus, an enlarged view of the area A may be shown as in FIG. 1C if dicing the leadframe array plate along the scribing lines S and S'. A plurality of the cup-shaped insulator 124 may be disposed on the leadframe array plate and may wrap the outer sides and fill the interspaces of the leadframe array plate.

It should be noted that recessions are formed at the cross sections of the scribing lines S and S' (FIG. 1E shows the recessions extending into the paper). These recessions may be arc recessions and may be formed by metal stamping. In an embodiment, these recessions may be commonly shared by adjacent LED packaging pieces, and the depth of the recessions (i.e., the height of the recession areas as shown in FIG. 1A) may be less than the thickness of the leadframe array plate (*i.e.*, the thickness of the first electrode and the second electrode as shown in FIG. 1A). For example, as shown in FIG. 1E, four LED packaging pieces share one of the recessions 106, and four LED packaging pieces share one of the recessions 112. Thus, after the dicing process, the first recession area 106 and the second recession area 112 are formed at the two corners of the LED package pieces, respectively. In addition, the recession areas 106 and 112 may be formed before the formation of the electroplating layer 108 and therefore can be coated with the electroplating layer 108.

Thus, by means of the formation of the first and the second recession areas 106 and 112, the side electrodes of the LED package piece may be protected by the electroplating layer 108. Furthermore, the recession areas 106 and 112 may have an enlarged surface area when compared to a planar surface. Thus, the LED package according to embodiments of the present disclosure may have a side electrode having an enlarged surface area and covered by the electroplating layer. Note that the LED packages shown in FIGS. 1A to 1D may be also employed at a separating type leadframe array plate as long as the recession areas at the cross sections of the scribing lines S and S' are formed before the formation of the electroplating layer.

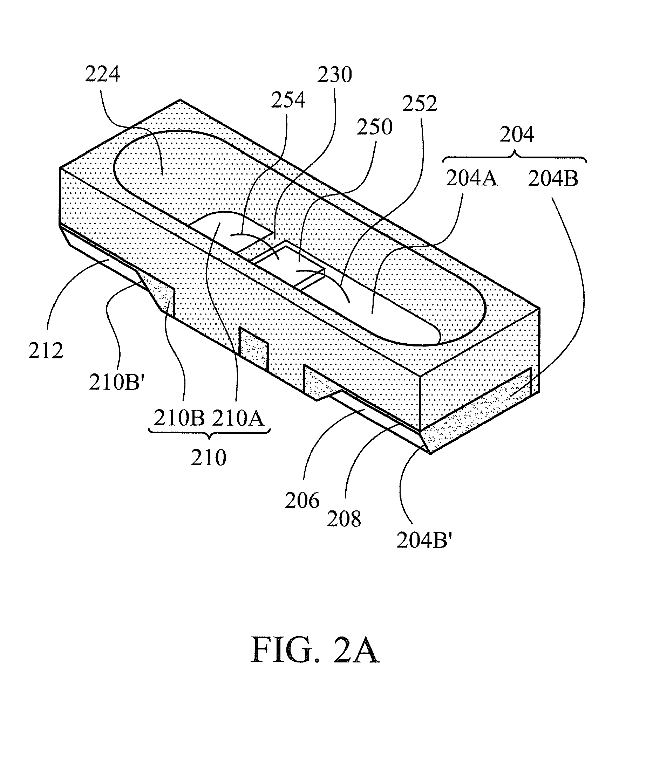

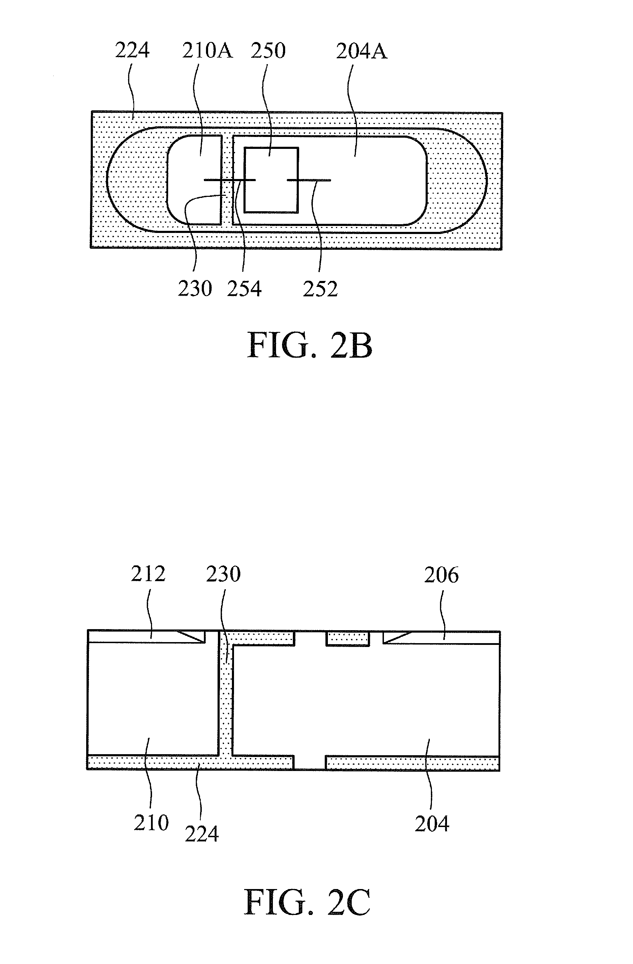

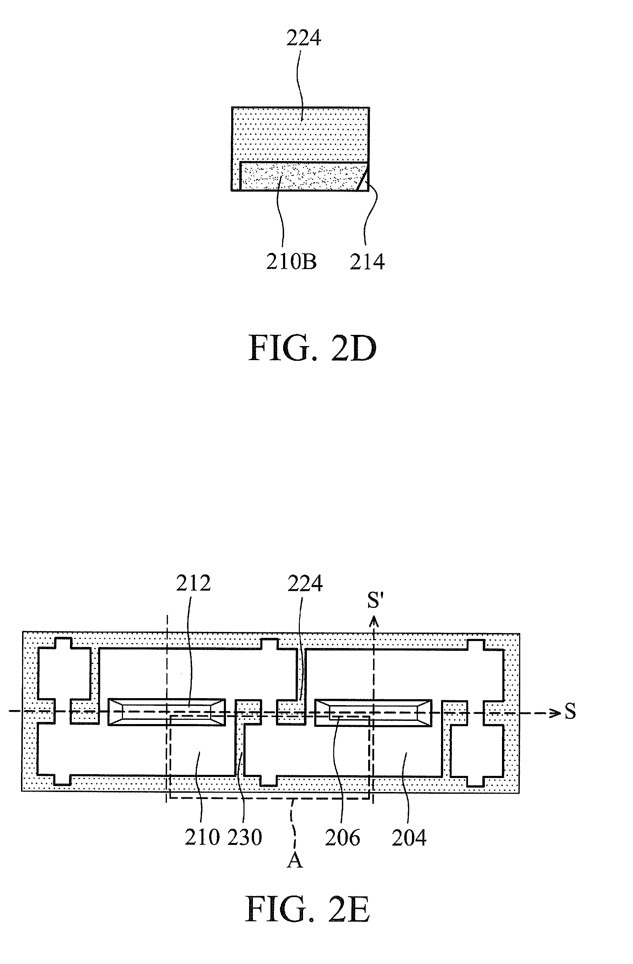

FIGS. 2A to 2E show an LED package according to another embodiment of the present disclosure. FIG. 2A shows a three-dimensional view of the LED package according to another embodiment of the present disclosure. FIG. 2B shows a top view of the LED package shown in FIG. 2A. FIG. 2C shows a bottom view of the LED package shown in FIG. 2A. FIG. 2D shows a side view of a side electrode of the LED package shown in FIG. 2A. Like reference numerals in this embodiment are used to indicate elements substantially similar to the elements described in the above embodiments, and a detailed description of the substantially similar elements will not be repeated. In this embodiment, the first recession area and the second recession area may have a concave having inclined sidewalls.

Referring to FIG. 2A, the LED package according to the present disclosure may comprise a first electrode 204 and the second electrode 210. The first electrode 204 may comprise a first functional area 204A and a first extension area 204B extending from the first functional area 204A. The second electrode 210 may comprise a second functional area 210A and the second extension area 210B extending from the second functional area 210A. The LED package is separated from the leadframe array plate, such as the leadframe array plate as shown in FIG. 2E. In an embodiment, the first electrode 204 and the second electrode 210 may be formed by stamping or dicing the leadframe array plate. Thus, the first electrode 204 and the second electrode 210 may comprise the raw material of the leadframe array plate, such as copper. The surfaces of the first electrode 204 and the second electrode 210 may be covered by an electroplating layer 208. The electroplating layer 208 may be selected from the group consisting of silver and gold.

A cup-shaped insulator 224 may be disposed on the first electrode 204 and the second electrode 210 by wrapping them. An emitting concave may be formed at the inner side of the cup-shaped insulator 224 and expose the upper surfaces of the first functional area 204A and the second functional area 210A. An LED chip 250 may be mounted in the emitting concave. The LED chip 250 may electrically connect to the first functional area 204A of the first electrode 204 and the second functional area 210A of the second electrode 210 via the first wire 252 and the second wire 254, respectively. An interposed spacer 230 may be disposed at the bottom of the emitting concave and physically separate the first electrode 204 and the second electrode 210.

The first extension area 204B maybe located at the outer side of the first electrode 204A and have at least a portion exposed from the bottom of the outer side of the cup-shaped insulator 224. The second extension area 210B may also have at least a portion exposed from the bottom of the outer side of the cup-shaped insulator 224. The exposed portions of the first extension area 204B and the second extension area 210B may be located at the bottom of the same side of the cup-shaped insulator 224. The first extension area 204B and the second extension area 210B may be used as side electrodes of the LED package. In an embodiment, the first electrode 204 and the second electrode 210 may comprise a first recession area 206 and a second recession area 212, respectively. The first recession area 206 and the second recession area 212 may be located at two corners of the cup-shaped insulator 224. The two corners may be may be located at the two ends of an edge of the cup-shaped insulator 224. In addition, the first recession area 206 and the second recession area 212 may have a height less than the thickness of the first functional area 204A and the second functional area 210A. The first recession area 206 may be a concave having inclined sidewalls 204B'. Similarly, as shown in FIG. 2D, the second recession area 212 may also have inclined sidewalls 210B'. The size and shape of the first recession area 206 and the second recession area 212 may vary according to the needs of specific designs. Portions of the surfaces of the first extension area 204B and the second extension area 210B, such as the side surfaces of the first extension area 204B and the second extension area 210B in addition to the first and second recession areas 206 and 212, may be not covered by the electroplating layer 208. The exposed surfaces which are not covered by the electroplating layer 208 may be naked copper surfaces. The surfaces of the first recession area 204 and the second recession area 212 may be coated with the electroplating layer 208.

FIG. 2E shows a bottom view of a connection type leadframe array plate. The leadframe array plate may comprise a plurality of LED packaging pieces which are connected to each other. For example, the LED package shown in FIGS. 2A to 2D may be an LED packaging piece diced from the leadframe array plate. An area A may be defined by a plurality of parallel scribing lines S and a plurality of parallel scribing lines S'. A plurality of the cup-shaped insulator 224 may be disposed on the leadframe array plate and may wrap the outer sides and fill the interspaces of the leadframe array plate. These recessions 206 and 212 may be rectangular or trapezoidal recessions and may be formed by metal stamping. In an embodiment, these recessions 206 and 212 may be commonly shared by adjacent LED packages, and the depth of the recessions (*i.e.*, the height of the recession areas as shown in FIG. 2A) may be less than the thickness of the leadframe array plate (*i.e*., the thickness of the first electrode and the second electrode as shown in FIG. 2A). For example, as shown in FIG. 2E, four LED packaging pieces share one of the recessions 206, and four LED packaging pieces share one of the recessions 212. Thus, after the dicing process, the first recession area 206 and the second recession area 212 are formed at the two corners of the LED package pieces, respectively. In addition, the recession areas 206 and 212 may be formed before the formation of the electroplating layer 208. The first and the second recession areas 206 and 212 may be covered by the electroplating layer 208, and may be used as the side electrodes of the LED package.

Note that the LED packages shown in FIGS. 2A to 2D may be also employed at the separating type leadframe array plate as long as the recession areas at the cross sections of the scribing lines S and S' are formed before the formation of the electroplating layer.

By means of the formation of the first and the second recession areas 206 and 212, the side electrodes of the LED package piece may be protected by the electroplating layer 208. In addition, the recession areas 206 and 212 may have an enlarged surface area when compared to a planar surface. The LED package according to embodiments of the present disclosure may have a side electrode having an enlarged surface area and be covered by the electroplating layer.

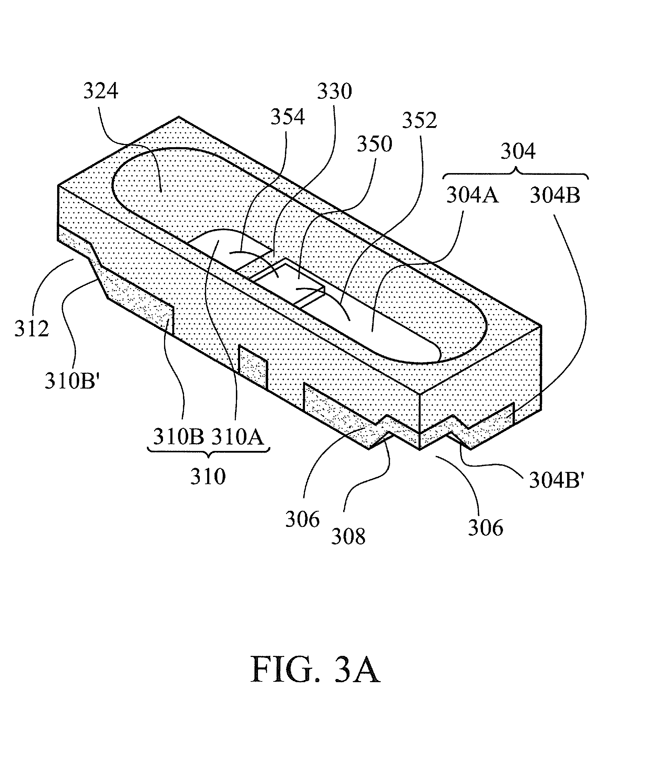

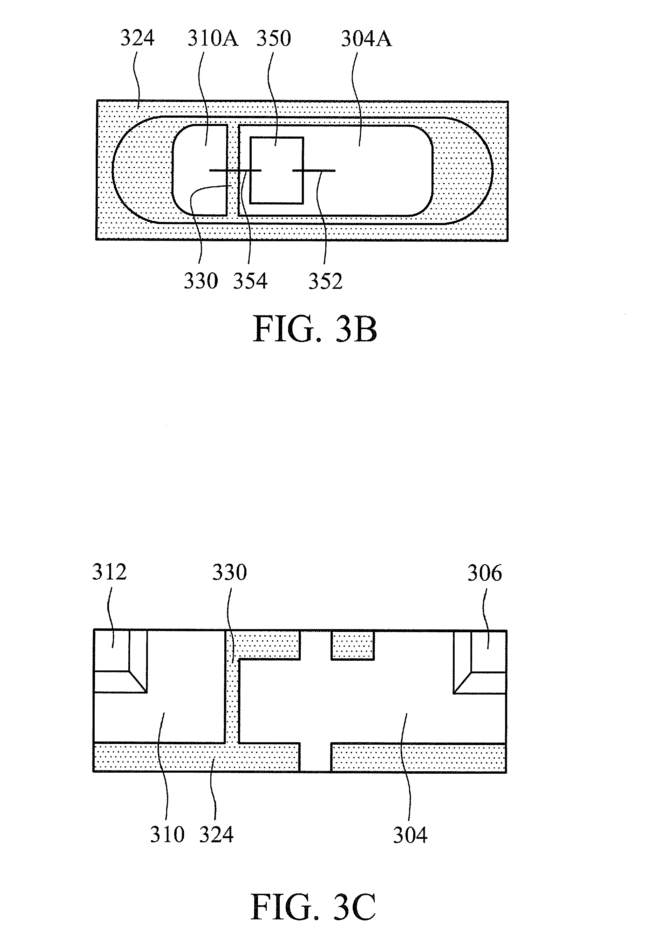

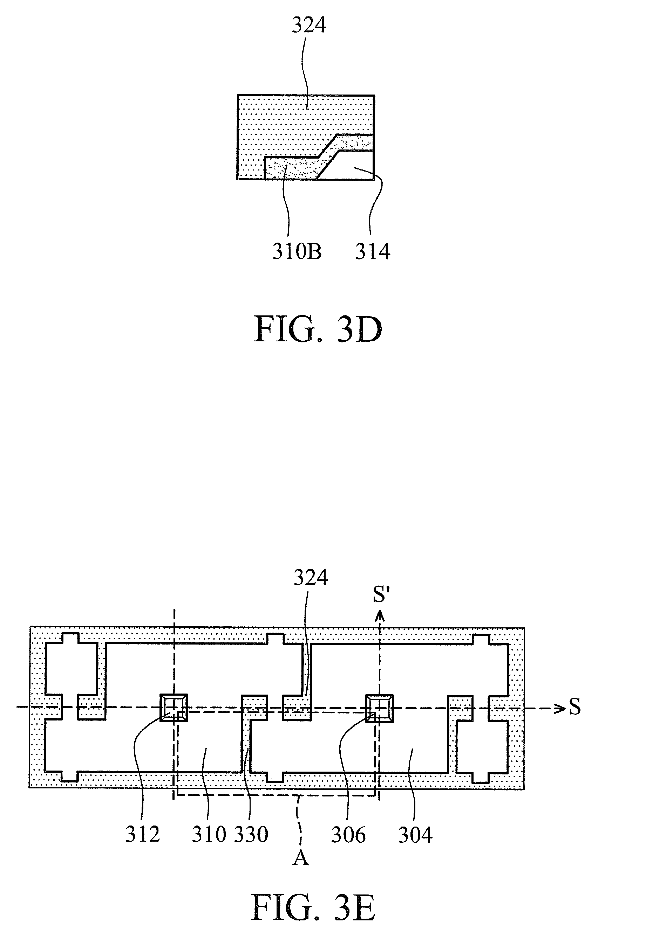

FIGS. 3A to 3E show an LED package according to yet another embodiment of the present disclosure. FIG. 3A shows a three-dimensional view of the LED package according to another embodiment of the present disclosure. FIG. 3B shows a top view of the LED package shown in FIG. 3A. FIG. 3C shows a bottom view of the LED package shown in FIG. 3A. FIG. 3D shows a side view of a side electrode of the LED package shown in FIG. 3A. Like reference numerals in this embodiment are used to indicate elements substantially similar to the elements described in the above embodiments, and a detailed description of the substantially similar elements will not be repeated. In this embodiment, the first recession area and the second recession area may have a height greater than the thickness of the first functional area and the second functional area.

Referring to FIG. 3A, the LED package according to the present disclosure may comprise a first electrode 304 and the second electrode 310. The first electrode 304 may comprise a first functional area 304A and a first extension area 304B extending from the first functional area 304A. The second electrode 310 may comprise a second functional area 310A and the second extension area 310B extending from the second functional area 310A. The LED package is separated from the leadframe array plate, such as the leadframe array plate as shown in FIG. 3E. In an embodiment, the first electrode 304 and the second electrode 310 may be formed by stamping or dicing the leadframe array plate. Thus, the first electrode 304 and the second electrode 310 may comprise the raw material of the leadframe array plate, such as copper. The surfaces of the first electrode 304 and the second electrode 310 may be covered by an electroplating layer 308. The electroplating layer 308 may be selected from the group consisting of silver and gold. A cup-shaped insulator 324 may be disposed on the first electrode 304 and the second electrode 310 by wrapping them. An emitting concave may be formed at the inner side of the cup-shaped insulator 324 and expose the upper surfaces of the first functional area 304A and the second functional area 310A. An LED chip 350 may be mounted in the emitting concave. The LED chip 350 may electrically connect to the first functional area 304A of the first electrode 304 and the second functional area 310A of the second electrode 310 via the first wire 352 and the second wire 354, respectively. An interposed spacer 330 may be disposed at the bottom of the emitting concave and physically separate the first electrode 304 and the second electrode 310.

The first extension area 304B may be located at the outer side of the first electrode 304A and have at least a portion exposed from the bottom of the outer side of the cup-shaped insulator 324. The second extension area 310B may also have at least a portion exposed from the bottom of the outer side of the cup-shaped insulator 324. The exposed portions of the first extension area 304B and the second extension area 310B may be located at the bottom of the same side of the cup-shaped insulator 324. The first extension area 304B and the second extension area 310B may be used as side electrodes of the LED package. In an embodiment, the first electrode 304 and the second electrode 310 may comprise a first recession area 306 and a second recession area 312, respectively. The first recession area 306 and the second recession area 312 may be located at two corners of the cup-shaped insulator 324. For example, the two corners may be may be located at the two ends of an edge of the cup-shaped insulator 324. In addition, the first recession area 306 and the second recession area 312 may have a height greater than the thickness of the first functional area 304A and the second functional area 310A. The first recession area 306 may be a concave having bending sidewalls 304B'. Similarly, as shown in FIG. 3D, the second recession area 312 may also have bending sidewalls 310B'. The size and shape of the first recession area 306 and the second recession area 312 may be varied according to the needs of designers. Portions of the surfaces of the first extension area 304B and the second extension area 310B, such as the side surfaces of the first extension area 304B and the second extension area 310B in addition to the first and second recession areas 306 and 312, may be not covered by the electroplating layer 308. The exposed surfaces which are not covered by the electroplating layer 308 may be naked copper surfaces. The surfaces of the first recession area 304 and the second recession area 312 may be coated with the electroplating layer 308 although they are located in the first extension area 204B and the second extension area 210B.

FIG. 3E shows a bottom view of a connection type leadframe array plate. The leadframe array plate may comprise a plurality of LED packaging pieces which are connected to each other. For example, the LED package shown in FIGS. 3A to 3D may be an LED packaging piece diced from the leadframe array plate. An area A may be defined by a plurality of parallel scribing lines S and a plurality of parallel scribing lines S'. A plurality of the cup-shaped insulator 324 may be disposed on the leadframe array plate and may wrap the outer sides and fill the interspaces of the leadframe array plate. These recessions 306 and 312 may be rectangular or trapezoidal recessions and may be formed by metal stamping. In an embodiment, these recessions 306 and 312 may be commonly shared by adjacent LED packages, and the depth of the recessions (*i.e.,* the height of the recession areas as shown in FIG. 3A) may be greater than the thickness of the leadframe array plate (*i.e.,* the thickness of the first electrode and the second electrode as shown in FIG. 3A). For example, as shown in FIG. 3E, four LED packaging pieces share one of the recessions 306, and four LED packaging pieces share one of the recessions 312. Thus, after the dicing process, the first recession area 306 and the second recession area 312 are formed at the two corners of the LED package pieces, respectively. In addition, the recession areas 306 and 312 may be formed before the formation of the electroplating layer 308. The first and the second recession areas 306 and 312 may be covered by the electroplating layer 308, and may be used as the side electrodes of the LED package.

Note that the LED package shown in FIGS. 3A to 3D may be also employed at the separating type leadframe array plate as long as the recession areas at the cross sections of the scribing lines S and S' are formed before the formation of the electroplating layer.

By means of the formation of the first and the second recession areas 306 and 312, the side electrodes of the LED package piece may be protected by the electroplating layer 308. In addition, the recession areas 306 and 312 may have an enlarged surface area when compared to a planar surface. The LED package according to embodiments of the present disclosure may have a side electrode having an enlarged surface area and be covered by the electroplating layer.

While the preferred embodiments of the disclosure have been described above, it will be recognized and understood that various modifications can be made to the disclosure and the appended claims are intended to cover all such modifications which may fall within the spirit and scope of the invention.

## Claims

1. A light-emitting diode package, comprising:
a leadframe, comprising:
a first electrode including a first functional area and a first extension area extending from the first functional area;
a second electrode including a second functional area and a second extension area extending from the second functional area;
a cup-shaped insulator, wrapping the first electrode and the second electrode, comprising an emitting concave formed at the inner side of the cup-shaped insulator and exposing the upper surfaces of the first functional area and the second functional area, wherein portions of the first extension area and the second extension area are exposed from the bottom of the outer side of the cup-shaped insulator;
an interposed spacer disposed at the bottom of the cup-shaped insulator for physically separating the first electrode and the second electrode; and
an electroplating layer partially covering the surfaces of the first electrode and the second electrode.

2. The light-emitting diode package according to claim 1, wherein the exposed first extension area and the exposed second extension area comprise a first recession area and a second recession area, respectively.

3. The light-emitting diode package according to claim 2, wherein the first recession area and the second recession area are disposed at the bottom of the same side of the cup-shaped insulator.

4. The light-emitting diode package according to claim 3, wherein the first recession area and the second recession area are at two corners of the cup-shaped insulator, respectively.

5. The light-emitting diode package according to claim 4, wherein the first recession area and the second recession area comprise arc sidewalls, inclined sidewalls, or bending sidewalls.

6. The light-emitting diode package according to claim 5, wherein the first recession area and the second recession area are formed by stamping.

7. The light-emitting diode package according to claim 1, wherein the electroplating layer is selected from the group consisting of gold and silver.

8. The light-emitting diode package according to claim 1, further comprising an LED chip mounted the first functional area and the second functional area.

9. The light-emitting diode package according to claim 1, further comprising an LED chip mounted the first functional area or the second functional area.

10. The light-emitting diode package according to claim 8, wherein the LED chip electrically connects to the first functional area and the second functional area.

11. The light-emitting diode package according to claim 9, wherein the LED chip electrically connects to the first functional area and the second functional area via wire bonding.

12. The light-emitting diode package according to claim 1, wherein the cup-shaped insulator comprises a themnosetting resin.

13. The light-emitting diode package according to claim 12, wherein the thermosetting resin comprises an epoxy resin, a silicone resin or combinations thereof.
